# EUROPÄISCHE PATENTSCHRIFT

(11) **EP 1 472 729 B1**
(45) Veröffentlichungstag und Bekanntmachung des Hinweises auf die Patenterteilung: **11.10.2017**
(21) Anmeldenummer: 02806317.0
(22) Anmeldetag: 05.12.2002
(51) Int. Cl.: H01L 23/36, B21C 23/14

(54) **KÜHLKÖRPER FÜR HALBLEITERBAUELEMENTE ODER DGL. EINRICHTUNGEN, VERFAHREN ZU DESSEN HERSTELLUNG UND WERKZEUG ZUR DURCHFÜHRUNG DES VERFAHRENS**
HEAT SINK FOR SEMICONDUCTOR COMPONENTS OR SIMILAR DEVICES, METHOD FOR PRODUCING THE SAME AND TOOL FOR CARRYING OUT SAID METHOD
CORPS DE REFROIDISSEMENT POUR COMPOSANTS SEMI-CONDUCTEURS OU DISPOSITIFS ANALOGUES, SON PROCEDE DE PRODUCTION, ET OUTIL POUR LA MISE EN OEUVRE DE CE PROCEDE

(30) Priorität: 02.01.2002 DE 10200019
(43) Veröffentlichungstag der Anmeldung: 03.11.2004
(73) Patentinhaber: Constellium Switzerland AG, 8048 Zürich (CH)
(72) Erfinder: BOCK, Uwe, 78224 Singen (DE); GRAF, Werner, 78234 Engen (DE); BOCK, Stephan, 78224 Singen (DE)
(74) Vertreter: Constellium - Propriété Industrielle
(86) Internationale Anmeldenummer: PCT/EP2002/013764
(87) Internationale Veröffentlichungsnummer: WO 2003/061000

(56) Entgegenhaltungen:
- DE-A- 2 502 472
- DE-A- 3 518 310
- PATENT ABSTRACTS OF JAPAN vol. 1998, no. 04, 31. März 1998 (1998-03-31) & JP 09 321186 A (JANOME SEWING MACH CO LTD), 12. Dezember 1997 (1997-12-12)

## Beschreibung

Die Erfindung betrifft einen Kühlkörper für Halbleiterbauelemente nach Anspruch 1. Zudem erfasst die Erfindung ein Verfahren zum Herstellen eines solchen Kühlkörpers.

Kühlkörper dieser Art sind der DE 25 02 472 A1 zu entnehmen; an einem Kühlkörper für Thyristoren sind sich konisch zum Nutengrund hin verjüngende Einsatznuten der Basisgehäuseplatte für die Kühlrippen vorgesehen. Diese werden mit Übermaß in die -- mit Längsnuten in den beiden Seitenwänden versehenen -- Einsatznuten eingepresst. Während in diesem Falle eine Mindestdicke der Rippe erforderlich ist, um die notwendigen Druckkräfte beim Fügeverfahren aufnehmen zu können, ist bei dem Verfahren nach DE 35 18 310 A1 nur ein formschlüssiger Verbund erreichbar.
Nach der Lehre dieser Druckschrift werden stranggepresste Vollprofile mit seitlichen Ausformungen als Kühlrippen in die Einsatznuten der gesondert erzeugten Sockelplatte formschlüssig eingesetzt. Die Nutwände der Einsatznut werden nach dem Einbringen der Kühlrippe durch ein -- zwischen zwei Kühlrippen einfahrbares -- keilartig ausgebildetes Werkzeug verformt, das dazu in eine Hilfsnut V-förmigen Querschnitts eingesetzt wird und teilweise den Werkstoff des Gehäusesockels in Parallelnuten der Kühlrippe drückt.

In beiden Fällen ist die einsetzbare Rippenzahl -- und damit die erreichbare Wärme abführende Oberfläche -- einerseits durch die erforderliche Mindestdicke der Kühlrippen sowie andererseits durch die notwendige Mindestbreite der Zwischennuten begrenzt.

In Kenntnis dieses Standes der Technik haben sich die Erfinder die Aufgabe gestellt, eine neue Kühlkörperform und neues Fertigungsverfahren zu entwickeln, dank deren eine höhere Rippenzahl und damit eine größere Oberfläche bei gleichzeitig verbessertem Wärmeübergang zwischen Kühlkörperbasis und eingsetzten Kühlrippen erreicht zu werden vermag.

Zur Lösung dieser Aufgabe führt die Lehre des unabhängigen Anspruches; die Unteransprüche geben günstige Weiterbildungen an. Zudem fallen in den Rahmen der Erfindung alle Kombinationen aus zumindest zwei der in der Beschreibung, der Zeichnung und/oder den Ansprüchen offenbarten Merkmale.

Erfindungsgemäß verlaufen auf den Oberflächen der Zwischenrippen in Abstand zueinander Querrippen als Stauchwülste, die formschlüssig an den Kupplungssockel anschließen und die Bindung verbessern.

Nach einem weiteren Merkmal der Erfindung sind die niedrigen Zwischenrippen und Einsatznuten von rechteckförmigem bis leicht trapezförmigem Querschnitt.

Im Rahmen der Erfindung liegt ein Verfahren zum Herstellen des Kühlkörpers, bei dem nach dem Einsetzen der Kühlrippe die Zwischenrippe der Sockelplatte durch Druck auf deren Rippenoberfläche verformt und auf der Oberfläche der Zwischenrippen in Abstand zueinander zwischen zwei Kühlrippen verlaufende Querrippen als Stauchwülste hergestellt werden und bei dem eine Druckquerkomponente sowie eine Relativbewegung zwischen dem Kupplungssockel und den ihn flankierenden Nutenwänden erzeugt werden. Durch den nach dem Einsetzen der Kupplungssockel auf die Zwischenrippenvon oben her durch eine verhältnismäßig breite und stumpfe Presskante -- ausgeübten Pressdruck werden letztere also partiell verformt, und es entstehen die genannten Stauchwülste auf der Zwischenrippe, welche dem Kupplungssockel formschlüssig anliegen. Neben den sich beim Verformungsprozess bildenden Druckquerkomponenten wird eine Relativbewegung zwischen den Nutwänden und dem Kupplungssockel erreicht, die im Zusammenwirken zumindest teilweise zu Kaltverschweißungen führt. Nach dem eigentlichen Druckvorgang können die dabei entstandenen Querrippen nochmals mit Druck beaufschlagt und so zusätzlich verpresst werden.

Als besonders günstig für dieses Verfahren hat sich ein Werkzeug erwiesen, welches zwischen zwei Kühlrippen absenkbar ausgebildet ist sowie am Bodenrand eines plattenartigen Einsatzabschnittes mit mehreren Zähnen ausgestattet ist, die als Druckflächen für die Zwischenrippen der Sockelplatte dienende Zahnstirnkanten anbieten. Die Länge dieser Zahnstirnkanten entspricht bevorzugt dem Abstand von Querrippen auf der Oberfläche der Zwischenrippe. Von der Zahnstirnkante gehen Zahnflanken aus, die in einem spitzen Winkel nach außen geneigt sind.

Zudem hat es sich als günstig erwiesen, dass das freie Ende der Zähne querschnittlich teilkreisförmig oder trapezförmig oder gar dreiecksförmig ausgebildet ist.

In einer bevorzugten Ausgestaltung ist das Werkzeug als spachtelartige Werkzeugplatte mit linearer Anordnung der Zahnstirnkanten zinnenartig vorgesehener Zähne hergestellt, wobei von der linearen Strecke aus Zahnstirnkanten zumindest einends eine in einem Winkel geneigte Seitenkante ausgehen soll.

Nach einem anderen Merkmal der Erfindung sind die Zähne an einem Einsatzabschnitt der Werkzeugplatte angeordnet, dessen Querschnittsbreite geringer ist als der Abstand der Kühlrippen voneinander und an den ein Greifabschnitt anschließt, der bevorzugt mit einem Gesamtwerkzeug verbunden zu werden vermag. Im übrigen soll die Dicke des Greifabschnittes größer sein als der Abstand der Kühlrippen voneinander, um die Stabilität beim Druckvorgang zu gewährleisten.

Bei einer anderen Ausgestaltung soll die Werkzeugplatte eine kreisförmige Zahnscheibe sein, die um eine Welle dreht und dabei den tangential laufenden Kühlkörper bearbeitet.

Erfindungsgemäß kann der die Zähne enthaltenden Werkzeugplatte eine Werkzeugplatte mit linearem Bodenrand in Vorschubrichtung des bewegten Kühlkörpers nachgeordnet sein. Der mittels Pressen beschriebene Prozeßablauf mit taktweisem Vorschub der zu verbindenden Profilteile kann auch rollend durchgeführt werden. Dabei durchläuft die mit den Kühlrippen bestückte Sockelplatte als Basisprofil eine Station mit kreisförmigen Zahnscheiben und nachfolgenden ebenen Scheiben.

Jedoch ist es auch möglich, ein Werkzeug so auszuführen, dass der Bodenrand der Werkzeugplatte teilweise Zähne aufweist und teilweise linear ausgebildet ist.

Weitere Vorteile, Merkmale und Einzelheiten der Erfindung ergeben sich aus der nachfolgenden Beschreibung bevorzugter Ausführungsbeispiel sowie anhand der Zeichnung; diese zeigt in:
- Fig. 1:: die Frontansicht eines Kühlkörpers mit Kühlrippen auf einer Sockelplatte;
- Fig. 2:: den Gehäusesockel der Fig. 1;
- Fig. 3:: eine Kühlrippe der Fig. 1;
- Fig. 4:: einen gegenüber Fig. 1 vergrößerten Schnitt durch einen Bereich des Kühlkörpers;
- Fig. 5:: die Draufsicht auf die Sockelplatte;
- Fig. 6:: einen vergrößerten Ausschnitt aus Fig. 5;
- Fig. 7:: den vergrößerten Längsschnitt durch Fig. 6 nach deren Linie VII-VII;
- Fig. 8:: eine Seitenansicht eines Druckwerkzeuges zum Herstellen des Kühlkörpers;
- Fig. 9:: eine teilweise geschnittene Stirnansicht des Druckwerkzeuges;
- Fig. 10,11:: jeweils einen vergrößerten Ausschnitt aus Fig. 8 bzw. 9 nach deren Pfeil X bzw. XI;
- Fig. 12:: eine teilweise Seitenansicht eines Kühlkörpers mit aufgesetztem Druckwerkzeug und nachgeordnetem Zusatzwerkzeug;
- Fig. 13:: eine Seitenansicht eines anderen Druckwerkzeugs;
- Fig. 14:: eine Stirnansicht zu Fig. 13;
- Fig. 15:: einen vergrößerten Ausschnitt aus Fig. 13 nach deren Pfeil XV;
- Fig. 16:: den Schnitt durch Fig. 15 nach deren Linie XVI-XVI;
- Fig. 17,19:: jeweils einen der Fig. 10 entsprechenden Ausschnitt zu anderen Ausgestaltungen des Druckwerkzeuges;
- Fig. 18,20:: jeweils einen Teilschnitt durch Fig. 17 bzw. 19 nach deren Linie XVIII-XVIII bzw. XX-XX.

Ein Kühlkörper 10 für Halbleiterbauelemente weist ein in der Zeichnung aus Gründen der Übersichtlichkeit nicht weiter dargestelltes Gehäuse mit einer Sockelplatte als Gehäusesockel 12 einer beispielsweisen Breite a von etwa 120 mm und einer Dicke b von hier etwa 10 mm auf.

In die Sockelplatte 12 sind parallel zueinander verlaufende Einsatznuten 14 etwa rechteckigen Querschnitts einer Breite c von etwa 4 mm und einer Tiefe e von etwa 3 mm eingeformt, die durch Längs- oder Zwischenrippen 16 ebenfalls rechteckigen Querschnitts einer -- gegenüber den Bodennuten 14 etwas geringeren -- Breite f voneinander getrennt sind. In diesen Einsatznuten 14 liegen in einem lichten Abstand z zueinander parallel verlaufende Kühlrippen 20 fest. Gehäusesockel bzw. Sockelplatte 12 und Kühlrippen 20 werden getrennt auf dem Wege des Strangpressens aus Metall -- insbesondere aus Aluminiumlegierungen -- hergestellt und anschließend zusammengefügt.

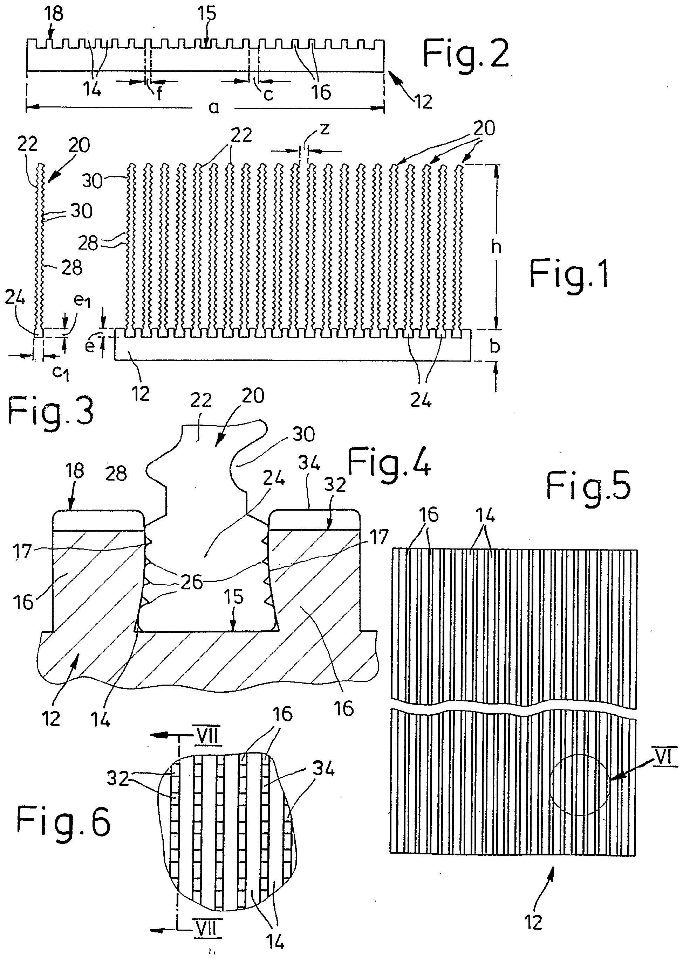

Die Kühlrippe 20 besteht aus einem -- in Einbaulage frei aufragenden -- plattenartigen Rippenkörper 22 der Höhe h von hier etwa 60 mm sowie einem Kupplungssockel 24, dessen Querschnitt etwa jenem der Einsatznuten 14 entspricht; in Fig. 3 sind die Sockelbreite mit c₁ und die Sockelhöhe mit e₁ gekennzeichnet. In die beiden freien Seitenflächen des Rippenkörpers 22 jeder Kühlrippe 20 sind -- durch Rippen 28 getrennte -- Längsnuten 30 so eingeformt, dass die Rippen 28 der einen Seitenfläche den Längsnuten 30 der anderen Seitenfläche gegenüberstehen (Fig. 4).

Der Kupplungssockel 24 wird in die Einsatznut 14 der Sockelplatte 12 eingeschoben, bis er dem Nutentiefsten 15 aufsitzt. Zur besseren Lagesicherung zwischen den Nutwänden 17 benachbarter Zwischenrippen 16 ist -- wie Fig. 4 zeigt - - jede Flankenfläche des Kupplungssockels 24 mit querschnittlich eine sägezahnartige Anordnung ergebenden Längseinformungen 26 versehen.

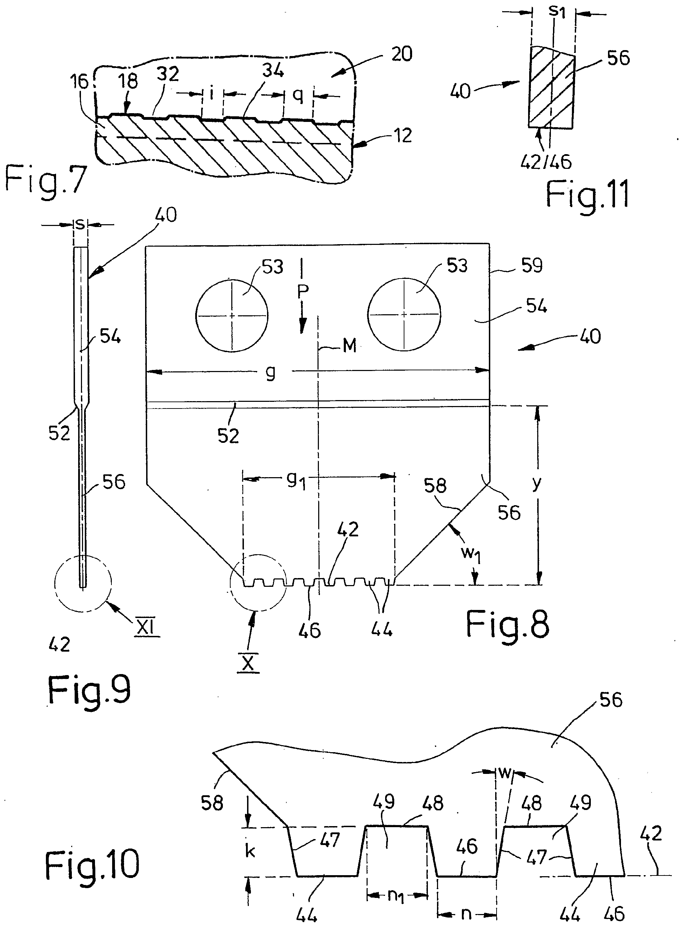

Nach dem Einsetzen des Kupplungssockels 24 in die Einsatznut 14 wird auf die Oberfläche 18 der Zwischenrippe 16 ein plattenähnliches -- in Pfeilrichtung P der Fig. 8 druckbelastetes -- Werkzeug 40 aufgesetzt, dessen jener Oberfläche 18 zugekehrter Bodenrand 42 mit einer zinnenartigen Reihe von Zähnen 44 ausgestattet ist. Der Länge n der -- jenen Bodenrand 42 bestimmenden -- Zahnstirnkanten 46 entspricht im übrigen die Weite i von Quernuten oder - mulden 32 in der Oberfläche 18 der bearbeiteten Längsrippe 16; diese Quermulden 32 entstehen bei Ausübung des Pressdruckes P als Eindrücke jener Zähne 44. Von deren Zahnstirnkanten 46 gehen -- in einem Winkel w von etwa 10° zur Mittellinie M der Werkzeugplatte 40 -- Zahnflanken 47 aus, die an zu den Zahnstirnkanten 46 in einem Abstand k parallelen Innenkonturen 48 der Länge n₁ der Randeinformungen oder Zahnlücken 49 zwischen den Zähnen 44 enden.

Fig. 7 verdeutlicht das Profil einer durch die Werkzeugplatte 40 behandelten Zwischenrippe 16 mit in Abständen q zueinander verlaufenden Quermulden 32 jener Weite i, zwischen denen Querrippen als Stauchwülste 34 verlaufen, deren Oberfläche von einem Abschnitt der Rippenoberfläche 18 gebildet wird.

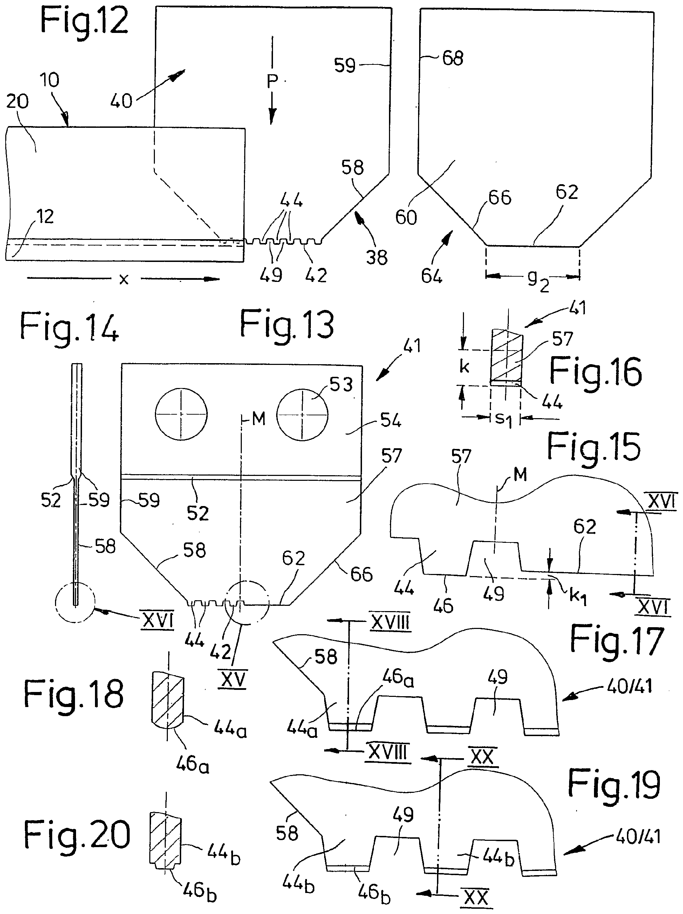

Die spachtelartige Werkzeugplatte 40 der Fig. 8, 12 besteht aus einer Stahlplatte der Breite g, die in einen -- Anschlussbohrungen 53 für nicht wiedergegebene Halteschrauben aufweisenden -- oberen Greifabschnitt 54 der Dicke s sowie einen unteren Einsatzabschnitt 56 geringerer Dicke s₁ unterteilt ist. Den Verjüngungsbereich 52 zwischen diesen Abschnitten 54, 56 quert die oben erwähnte Mittellinie M der Werkzeugplatte 40, die gleichzeitig Symmetriegerade ist; da die Länge g₁ des erwähnten Bodenrandes 42 etwa der Hälfte der oberen Breite g der Stahlplatten entspricht, gehen von beiden Enden des Bodenrandes 42 -- zu diesem in einem Winkel w₁ von 45° -- geneigte Seitenkanten 58 aus, die etwa in der Hälfte der Höhe y des Einsatzabschnitts 56 an die parallel zueinander verlaufenden oberen Seitenkanten 59 der Werkzeugplatte 40 anschließen.

Bei Fertigung des Kühlkörpers 10 wird dieser gemäß Fig. 12 in Vorschubrichtung x einem die zueinander parallel stehenden Werkzeugplatten 40 enthaltenden Druckwerkzeug 38 zugeführt, wobei die Werkzeugplatten 40 zwischen die Kühlrippen 20 des Kühlkörpers 10 gelangen; die Bodenränder 42 der Werkzeugplatten 40 werden auf die Oberflächen 18 der Längsrippen 16 des Gehäusesockels bzw. der Sockelplatte 12 aufgesetzt und verformen die Längsrippen 16 unter Pressdruck P in oben erörterter Weise.

Die im Bereich der Zahnlücken 49 entstehenden -- weniger verformten -- Zonen der erwähnten Querrippen 34 werden in diesem Beispiel mit dem glatten Bodenrand 62 einer Druckplatte 60 eines nachgeordneten Zusatzwerkzeuges 64 so nachverformt, dass zwischen den Nutwänden 17 und den zugeordneten Flankenflächen des Kupplungssockels 24 ein Formschluss entsteht.

Die Kontur der Druckplatte 60 des Zusatzwerkzeuges 64 entspricht jener der Werkzeugplatte 40, wie Fig. 12 erkennen läßt; auch an ihr gehen vom Bodenrand 62 der Länge g₂ geneigte Seitenkanten 66 aus, die in parallele Seitenkanten 68 übergehen.

Bei der Werkzeugplatte 41 der Fig. 13 ist der links von der Mittellinie M liegende Bereich des Einsatzabschnitts 57 entsprechend dem Einsatzabschnitt 56 der Werkzeugplatte 40 (Fig. 8) ausgebildet, die Mittellinie M verläuft in der zur Mitte hin letzten Zahnlücke 49 dieser Zahnung. Der rechte Bereich des Einsatzabschnitts 57 ist wie die Druckplatte 60 des Zusatzwerkzeuges 64 mit glattem Bodenrand 62 ausgestattet. Dieser liegt in einem Abstand k₁ zu den Zahnstirnkanten 46. Hier sind die vorab zu Fig. 12 beschriebenen Werkzeugplatten 40, 60 in einer Platte 41 integriert.

Die Beispiele der Fig. 17, 18 bzw. 19, 20 zeigen, dass die Zähne 44ₐ, 44_{b} der auch als Fügemeißel zu bezeichnenden Werkzeugplatte 40, 41 mit einer querschnittlich teilkreisförmigen Stirnfläche 46ₐ oder einer trapezartigen Stirnfläche 46_{b} ausgestattet sein können - nicht gezeigt ist eine mögliche dreiecksförmige Gestaltung.

## Patentansprüche

1. Kühlkörper (10) für Halbleiterbauelemente, insbesondere aus einer stranggepreßten Aluminiumlegierung, mit in Abstand zueinander von einer Sockelplatte (12) aufragenden Kühlrippen (20), die jeweils mit einem querschnittlich etwa rechteckigen Kupplungssockel (24) in einer in die Oberfläche der Sockelplatte (12) eingebrachten Einsatznut (14) von diese seitlich begrenzenden Längs- oder Zwischenrippen (16) klemmend gehalten sind, wobei die Kupplungssockel (24) formschlüssig in ihren Einsatznuten (14) gehalten und zumindest abschnittsweise mit der Sockelplatte (12) kaltverschweißt sind und insbesondere die Einsatznuten (14) jeweils einen etwa rechteckigen Querschnitts aufweisen, **dadurch gekennzeichnet,**
**dass** auf den Oberflächen der Zwischenrippen (16) in Abstand (i) zueinander Querrippen (34) als Stauchwülste verlaufen, die formschlüssig an die Kupplungssockel (24) anschließen.

2. Kühlkörper nach Anspruch 1, **dadurch gekennzeichnet, dass** der etwa rechteckige Querschnitt der Kupplungssockel (24) und/oder der Einsatznuten (14) von geringer Höhe (e, e₁) ist.

3. Verfahren zum Herstellen eines Kühlkörpers (10) durch Einsetzen von Kühlrippen (20) in eine Sockelplatte (12) mit Zwischenrippen (16), nach Anspruch 1 oder 2, **dadurch gekennzeichnet, dass** nach dem Einsetzen der Kühlrippen (20) die Zwischenrippen (16) der Sockelplatte (12) durch Druck (P) auf deren Rippenoberfläche (18) verformt und auf der Oberfläche (18) der Zwischenrippen (16) in Abstand (i) zueinander zwischen zwei Kühlrippen (20) verlaufende Querrippen (34) als Stauchwülste hergestellt werden, und dass eine Druckquerkomponente sowie eine Relativbewegung zwischen den Kupplungssockeln (24) und den sie flankierenden Nutenwänden (17) erzeugt werden.

4. Verfahren nach Anspruch 3, **dadurch gekennzeichnet, dass** die Querrippen (34) mit Druck beaufschlagt werden.

5. Verfahren nach Anspruch 3 oder 4, **dadurch gekennzeichnet, dass** zur Ausbildung der Querrippen (34) ein Werkzeug (40) verwendet wird, das am Bodenrand (42) eines plattenartigen Einsatzabschnittes (56) des zwischen zwei Kühlrippen (20) absenkbar ausgebildeten Werkzeuges (40, 41) mehrere Zähne (44) mit als Druckflächen für die Zwischenrippen (16) der Sockelplatte (12) dienenden Zahnstirnkanten (46) aufweist.

6. Verfahren nach Anspruch 5, **dadurch gekennzeichnet, dass** die Länge (n) der Zahnstirnkante (46) dem Abstand von Querrippen (34) auf der Oberfläche einer Zwischenrippe (16) entspricht.

7. Verfahren nach Anspruch 6, **dadurch gekennzeichnet, dass** Zahnflanken (47) vorgesehen sind, die von der Zahnstirnkante (46) in einem spitzen Winkel (w) nach außen geneigt sind.

8. Verfahren nach einem der Ansprüche 5 bis 7, **dadurch gekennzeichnet, dass** das freie Ende der Zähne (44a, 44b) querschnittlich teilkreisförmig oder trapezförmig oder dreiecksförmig ausgebildet ist.

9. Verfahren nach einem der Ansprüche 5 bis 8, **dadurch gekennzeichnet, dass** das spachtelartige Werkzeug (40, 41) mit linearer Anordnung der Zahnstirnkanten (46) zinnenartig vorgesehene Zähne (44) aufweist.

10. Verfahren nach Anspruch 9, **dadurch gekennzeichnet, dass** von der linearen Strecke aus Zahnstirnkanten (46) zumindest einends eine in einem Winkel (W1) geneigte Seitenkante (58) ausgeht.

11. Verfahren nach Anspruch 9 oder 10, **dadurch gekennzeichnet, dass** die Zähne (44) an einem Einsatzabschnitt (56) des Werkzeugs (40, 41) angeordnet sind, dessen Querschnittsbreite (S1) geringer ist als der Abstand (z) der Kühlrippen (22) voneinander und an den ein Greifabschnitt (54) anschließt.

12. Verfahren nach Anspruch 11, **dadurch gekennzeichnet, dass** die Dicke (s) des Greifabschnittes (54) größer ist als der Abstand (z) der Kühlrippen (20) voneinander.

13. Verfahren nach einem der Ansprüche 5 bis 8, **dadurch gekennzeichnet, dass** als Werkzeug eine kreisförmige Zahnscheibe verwendet wird.

14. Verfahren nach einem der Ansprüche 5 bis 13, **dadurch gekennzeichnet, dass** dem die Zähne (44) enthaltenden Werkzeug (40) eine Werkzeugplatte (64) mit linearem Bodenrand (62) in Vorschubrichtung (x) des Kühlkörpers (10) nachgeordnet ist.

15. Verfahren nach einem der Ansprüche 5 bis 13, **dadurch gekennzeichnet, dass** der Bodenrand des Werkzeugs (41) teilweise Zähne (44) aufweist und teilweise linear ausgebildet ist.

## Claims

1. Heat sink (10) for semiconductor components, made in particular from an extruded aluminium alloy, comprising cooling ribs (20) protruding at a distance from one another from a base plate (12), which cooling ribs are held in a clamping manner respectively by a coupling base which is approximately rectangular in cross section in an insertion groove (14) made in the surface of the base plate (12) by said laterally delimiting longitudinal or intermediate ribs (16), wherein the coupling base (24) are held in a form-fitting manner in their insertion grooves (14) and are cold-welded at least in some sections to the base plate (12) and in particular the insertion grooves (14) each have an approximately rectangular cross-section,
**characterised in**
**that** transverse ribs (34) with a spacing (i) from one another on the surfaces of the intermediate ribs (16) run as flashes which connect in a form-fitting manner with the coupling base (24).

2. Heat sink according to claim 1, **characterised in that** the approximately rectangular cross-section of the coupling base (24) and/or the insertion grooves (14) has a low height (e, e₁).

3. Method of producing a heat sink (10) by inserting cooling ribs (20) into a base plate (12) comprising intermediate ribs (16), according to claim 1 or 2, **characterised in that** after inserting the cooling ribs (20) the intermediate ribs (16) of the base plate (12) are deformed by pressure (P) on their rib surface (18) and on the surface (18) of the intermediate ribs (16) at a distance (i) form one another transverse ribs (34) running between two cooling ribs (20) are produced as flashes, and **in that** a pressure transverse component and a relative movement are produced between the coupling bases (24) and the groove walls (17) flanking the latter.

4. Method according to claim 3, **characterised in that** the transverse ribs (34) are charged with pressure.

5. Method according to claim 3 or 4, **characterised in that** a tool (40) is used for forming the transverse ribs (34), the tool comprising on the bottom edge (42) of a plate-like insertion section (56) of the tool (40, 41) designed to be lowerable between two cooling ribs (20) a plurality of teeth (44) with tooth front edges (46) serving as pressure surfaces for the intermediate ribs (16) of the base plate (12).

6. Method according to claim 5, **characterised in that** the length (n) of the tooth front edge (46) corresponds to the spacing of transverse ribs (34) on the surface of an intermediate rib (16).

7. Method according to claim 6, **characterised in that** tooth flanks (47) are provided which are outwardly inclined from the tooth front edge (46) at an acute angle (w).

8. Method according to any of claims 5 to 7,
**characterised in that** the free end of the teeth (44a, 44b) is designed to have a cross-section which is pitch circle-shaped, trapezoidal or triangular.

9. Method according to any of claims 5 to 8, **characterised in that** the spatula-like tool (40, 41) with a linear arrangement of the tooth front edges (46) comprises crenellated teeth (44).

10. Method according to claim 9, **characterised in that** a side edge (58) inclined at an angle (W1) issues from the linear section of the tooth front edges (46) at least at one end.

11. Method according to claim 9 or 10,
**characterised in that** the teeth (44) are arranged on an insertion section (56) of the tool (40, 41), the cross-sectional width (S1) of which is less than the spacing (z) of the cooling ribs (22) from one another and is abutted by a gripping section (54).

12. Method according to claim 11, **characterised in that** the thickness (s) of the gripping section (54) is greater than the spacing (z) of the cooling ribs (20) from one another.

13. Method according to any of claims 5 to 8, **characterised in that** a circular toothed disc is used as the tool.

14. Method according to any of claims 5 to 13,
**characterised in that** a tool plate (64) with a linear bottom edge (62) is arranged downstream in a feed-direction (x) of the heat sink (10) after the tool (40) containing the teeth (44).

15. Method according to any of claims 5 to 13,
**characterised in that** the bottom edge of the tool (41) partially has teeth (44) and is partially designed in a linear manner.

## Revendications

1. Corps de refroidissement (10) pour composants semi-conducteurs, en particulier en alliage d'aluminium extrudé, comprenant des ailettes de refroidissement (20) émergeant à distance les unes des autres d'une plaque de base (12), lesquelles ailettes (20) sont maintenues serrées, chacune à l'aide d'un socle de couplage (24) de section sensiblement rectangulaire, dans une rainure d'insertion (14) ménagée dans la surface de la plaque de base (12) et délimitée latéralement par des ailettes longitudinales ou intermédiaires (16), les socles de couplage (24) étant maintenus par concordance de forme dans leurs rainures d'insertion (14) et étant soudés à froid, au moins par endroits, sur la plaque de base (12) et, en particulier, les rainures d'insertion (14) présentant chacune une section sensiblement rectangulaire,
**caractérisé en ce que**
sur les surfaces des ailettes intermédiaires (16), à distance les unes des autres, s'étendent des ailettes transversales (34) sous forme de bourrelets de compression, qui sont raccordés par concordance de forme aux socles de couplage (24).

2. Corps de refroidissement selon la revendication 1, **caractérisé en ce que** la section sensiblement rectangulaire des socles de couplage (24) et/ou des rainures d'insertion (14) est de faible hauteur (e, e₁).

3. Procédé de fabrication d'un corps de refroidissement (10) par insertion d'ailettes de refroidissement (20) dans une plaque de base (12) pourvue d'ailettes intermédiaires (16) selon la revendication 1 ou 2, **caractérisé en ce que**, après l'insertion des ailettes de refroidissement (20), les ailettes intermédiaires (16) de la plaque de base (12) sont déformées par une pression (P) exercée sur leurs surfaces (18) et des ailettes transversales (34) s'étendant sur la surface (18) des ailettes intermédiaires (16) à une distance (i) les unes des autres entre deux ailettes de refroidissement (20) sont réalisées sous forme de bourrelets de compression, et **en ce qu'**il est généré une composante de pression transversale ainsi qu'un déplacement relatif entre les socles de couplage (24) et les parois de rainure (17) adjacentes à ces derniers.

4. Procédé selon la revendication 3, **caractérisé en ce que** les ailettes (34) sont soumises à une pression.

5. Procédé selon la revendication 3 ou 4, **caractérisé en ce que**, pour réaliser les ailettes transversales (34), on utilise un outil (40) qui présente au bord inférieur (42) d'une partie d'insertion (56) de type plaque de l'outil (40, 41), partie pouvant être abaissée entre deux ailettes de refroidissement (20), une pluralité de dents (44) dont les faces (46) servent de surfaces de pression pour les ailettes intermédiaires (16) de la plaque de base (12).

6. Procédé selon la revendication 5, **caractérisé en ce que** la longueur (n) de la face (46) des dents correspond à la distance entre ailettes transversales (34) sur la surface d'une ailette intermédiaire (16).

7. Procédé selon la revendication 6, **caractérisé en ce qu'**il est prévu des flancs (47) de dents, qui sont inclinés selon un angle aigu (w) vers l'extérieur à partir de la face (46) des dents.

8. Procédé selon une des revendications 5 à 7, **caractérisé en ce que** l'extrémité libre (44a, 44b) des dents est de section semi-circulaire ou trapézoïdale ou triangulaire.

9. Procédé selon une des revendications 5 à 8, **caractérisé en ce que** l'outil (40, 41) présentant une disposition linéaire des faces (46) des dents comporte des dents (44) crénelées.

10. Procédé selon la revendication 9, **caractérisé en ce que** de la portion linéaire des faces (46) des dents, part au moins à une extrémité une arête latérale (58) inclinée selon un angle (W1).

11. Procédé selon la revendication 9 ou 10, **caractérisé en ce que** les dents (44) sont agencées sur une partie d'insertion (56) de l'outil (40, 41), partie dont la largeur de section (SI) est inférieure à la distance (z) entre les ailettes de refroidissement (22) et sur laquelle est rapportée une partie de préhension (54).

12. Procédé selon la revendication 11, **caractérisé en ce que** l'épaisseur (s) de la partie de préhension (54) est supérieure à la distance (z) entre les ailettes de refroidissement (20).

13. Procédé selon une des revendications 5 à 8, **caractérisé en ce qu'**on utilise comme outil un disque denté circulaire.

14. Procédé selon une des revendications 5 à 13, **caractérisé en ce qu'**en aval de l'outil (40) comportant les dents (44), dans la direction d'avance (x) du corps de refroidissement (10), est disposée une plaque d'outil (64) présentant un bord inférieur (62) linéaire.

15. Procédé selon une des revendications 5 à 13, **caractérisé en ce que** le bord inférieur de l'outil (41) comporte en partie des dents (44) et est en partie de forme linéaire.
